# EUROPEAN PATENT SPECIFICATION

(11) **EP 2 006 413 B1**
(45) Date of publication and mention of the grant of the patent: **13.10.2010**
(21) Application number: 08157076.4
(22) Date of filing: 28.05.2008
(51) Int. Cl.: C23C 16/34, C23C 14/06, C22C 29/00, B23B 27/14

(54) **Coated cemented carbide for die and mould applications**
Beschichtetes Hartmetall für Stanz- und Formanwendungen
Carbure cimentée revêtue pour moule et applications de moulage

(30) Priority: 01.06.2007 SE 0701320
(43) Date of publication of application: 24.12.2008
(73) Proprietor: Sandvik Intellectual Property AB, 81181 Sandviken (SE)
(72) Inventor: Donnadieu, Pierre, 37230, Luynes (FR); Norgren, Susanne, SE-141 41, Huddinge (SE)
(74) Representative: Hägglöf, Henrik

(56) References cited:
- EP-A- 1 038 989
- EP-A- 1 347 076
- EP-A- 1 676 939
- EP-A- 1 798 310
- US-A1- 2002 051 887

## Description

The present invention relates to a coated cemented carbide cutting tool insert. More specifically the invention relates to PVD coated cemented carbide cutting tool inserts for semifinishing or finishing metal cutting operations.

High performance cutting tools must possess high wear resistance, high toughness properties and good resistance to plastic deformation. This is particularly valid when the cutting operation is carried out at high cutting speeds and/or at high feed rates when large amount of heat is generated.

Cemented carbide grades for metal machining applications generally contain WC, γ-phase, which is a solid solution of generally TiC, NbC, TaC and WC, and binder phase, generally Co and/or Ni. WC-Co cemented carbides having a fine grain size <1 µm are produced through the incorporation of grain growth inhibitors such as V, Cr, Ti, Ta and combinations thereof in the initial powder blend. Typical inhibitor additions are 0.5 to 5 wt-% of the binder phase.

EP 1 347 076 A1 describes a PVD-coated cutting tool insert with a cemented carbide substrate containing NbC and TaC and a coating with an inner TiₓAl_{y}N where 0.8≤x+y≤1.2 and 0.25≤x/y≤1.45. The inserts is particularly useful for milling at high cutting speeds in alloyed steels and milling in hardened steels.

It is an object of the present invention to provide inserts with a coated cemented carbide with improved wear resistance without sacrificing toughness and edge security, particularly useful for semifinishing or finishing operations of metal materials.

This object is solved by providing a cemented carbide insert consisting of a WC+Co-substrate with fine grain size provided with a PVD coating.

According to the present invention given in the claims 1 to 3 there is provided coated cemented carbide shaped inserts for semifinishing or finishing machining of metals, comprising a cemented carbide substrate, a wear resistant coating, and different insert geometries. The substrate comprises in addition to WC 5.5-8.5, preferably 6-8, wt-% Co and Cr such that the Cr/Co weight ratio is 0,08-0.12, preferably 0.09-0.11. The substrate also contains Ti and Ta in such amounts that the ratio
Me/Co=(at%Ti+at%Ta)/at%Co
is less than or equal to 0.014-(CW-Cr)*0.008 and higher than 0.0005 preferably higher than 0.0007 and CW-Cr is 0.75-0.95, preferably 0.78-0.93, where
CW-Cr= (magnetic-% Co +1.13*wt-%Cr)/wt-%Co
where magnetic-% Co is the weight percentage of magnetic Co and wt-% Co is the weight percentage of Co in the cemented carbide. The CW-Cr is a function of the W content in the Co binder phase. A CW-Cr of about 1 corresponds to a low W-content in the binder phase and a CW-Cr of 0.75-0.8 corresponds to a high W-content in the binder phase.

The coercivity is >20 kA/m, preferably 23-29 kA/m.

The sintered body may also contain small amounts of precipitations of additional phase or phases such as eta-phase, MX or M₇X₃, M₃X₂ where M=(Ti+Ta+Co+Cr+W) and X=C or N maybe allowed to a volume fraction of maximum 5.0 vol-% without detrimental effects.

The wear resistant coating comprises a homogeneous AlₓTi₁₋ₓN-layer with x=0.6-0.67, preferably x=0.62. The thickness of the layer is >1 µm, preferably >1.8 µm but <3.8 µm, preferably <3.0 µm. Both the composition and the thickness are measured on the flank face of the insert 0.2 mm below the nose radius and in the centre of the cutting edge.

The present invention also relates to a method of making cemented carbide cutting tool inserts given in claims 4 to 8 for semifinishing or finishing operations in milling applications, comprising the following steps
providing a cemented carbide substrate with a composition according to above by:
- wet milling submicron powders of tungsten carbide, cobalt, Ti and Ta added as TiC, TaC, (Ti,W)C, (Ta,W)C or (Ti,Ta,W)C and at least one of Cr₃C₂, Cr₂₃C₆ and Cr₇C₃ to obtain a slurry,
- drying the slurry to obtain a powder,
- pressing the powder to inserts,
- sintering the inserts in vacuum,
- possibly performing an isostatic gas pressure step during sintering temperature or at the final stage of sintering
- possibly grinding the inserts to desired shapes
- depositing by arc evaporation technique whilst maintaining a partial pressure of nitrogen in the recipient, and using the appropriate selection of active evaporation sources and -rates
- a wear resistant coating comprising a homogeneous AlₓTi₁-ₓN-layer with x=0.6-0.67, preferably x=0.62. The thickness of the layer is >1 µm, preferably >1.8 µm but <3.8 µm, preferably <3.0 µm, the composition and the thickness being measured on the flank face 0.2 mm below the nose radius and in the centre of the cutting edge.

The present invention according to claim 9 relates to the use of inserts according to above for die and mould semifinishing and finishing operations in milling applications of work pieces with a hardness of 30-65 HRC.

The present invention according to claim 10 relates to the use of inserts according to above for machining of heat resistant super alloys(HRSA), as Inconel 718, Inconel 625, Waspaloy, Udimet 720.
- at cutting speeds of 20 - 180 m/min, feed rates of 0.05 - 0.3 mm/rev and depth of cut of 0.2 - 0.6 mm in turning applications and
- at cutting speeds of 15 - 180 m/min, tooth feed of 0.05 - 0.2 mm/tooth and axial depth of cut of 0.25 - 7 mm in milling application.

The present invention according to claim 11 relates to the use of inserts according to above for machining of stainless steel, as AISI/SAE 304, San-Mac 316L, SAF2205, SAF2507,
- at cutting speeds of 70 - 200 m/min, feed rates of 0.1 - 0.4 mm/rev and depth of cut of 0.3 - 2.5 mm in turning applications and
- at cutting speeds of 60 - 200 m/min, tooth feed of 0.05 - 0.2 mm/tooth and axial depth of cut of 0.5 - 2.5 mm in milling application.

The present invention according to claim 12 relates to the use of inserts according to above for milling of tool steel, at a cutting speed from 70 up to 120 m/min, a feed from 0.1 to 0.35 mm/tooth and depth of cut from 1 to 3 mm.

The present invention according to claim 13 relates to the use of inserts according to above for turning of hardened steel, at a cutting speed from 40 up to 60 m/min and a feed from 0.03 to 0.05 mm/rev and depth of cut from 0.2 to 0.5 mm.

The present invention according to claim 14 relates to the use of inserts according to above for milling of hard cast steel, at a cutting speed from 50 up to 100 m/min and a feed from 0.1 to 0.3 mm/tooth and depth of cut from 0.5 to 1,5 mm.

The present invention according to claim 15 relates to the use of inserts according to above for machining of cast iron,
- at cutting speeds of 200 - 400 m/min, feed rates of 0.1 - 0.5 mm/rev and depth of cut of 0.5 - 4 mm in turning applications and
- at cutting speeds of 150 - 350 m/min, tooth feed of 0.05 - 0.3 mm/tooth and axial depth of cut of 0.05 - 2.5 mm in milling application.

### Example 1

Tungsten carbide powder, 7 wt% very fine grained cobalt powder and 0.7 wt-% Cr added as H.C.Starck fine grained Cr₃C₂-powder, 0.014 wt-% Ti and 0.010 wt-% Ta, added as TiC and TaC, were wet milled together with conventional pressing agents. After milling and spray drying the powder was pressed to shape blanks for inserts and sintered at 1410 °C. The sintered material had a coercivity of 27 kA/m corresponding to a WC grain size of about 0.8-0.9 µm. Substrate data are summarised in the table below.

| | Ti, wt-% | Ta, wt-% | Me/Co | Co, wt-% | Cr, wt-% | Cr/ Co | CW-Cr | 0.014-(CW-Cr)*0.008 |
|---|---|---|---|---|---|---|---|---|
| Substrate data | 0.014 | 0.010 | 0.0029 9 | 7.00 0 | 0.70 0 | 0.10 0 | 0.85 | 0.0062 |

The so obtained cemented carbide inserts were ground to obtain the finished shapes.

The as-ground inserts were wet cleaned. A homogeneous (Ti,Al)N layer was deposited by cathodic arc evaporation using a target material consisting of a Ti_{0.33}Al_{0.67} alloy in an N₂ gas atmosphere. The thickness of the layer was 2.5 µm and it consisted of a homogeneous layer with the composition Al_{0.62}Ti_{0.38}N as determined by EDS-analysis.

### Example 2.

Inserts from Example 1 were tested and compared with inserts of a commercially available market reference (grade, coating, shape) for the intended application area. Wear resistance test was done.

The test represents the upper range in terms of work piece hardness.

### Type of test

A die and mould application, a straight shaped mould with the cutter body in the orthogonal milling position.

| Machine: | Deckel Maho, DMU60T |
|---|---|
| Work piece steel | DIN 1.2320. HRC 62 |
| Cutting speed, V_{c} (m/min) | 70 |
| Insert ref: | PPH1600CL1 |
| Tooth feed, f_{z}, (mm/tooth) | 0.36 |
| Depth of cut, Axial/Radial(mm) | 0.25/0.3 |
| Ø effective | 3.40 mm = constant |
| Cooling | Dry |
| Tool life criterion | Max flank wear 0.15 mm |
| | |

| Result: | Tool life |
|---|---|
| Invention (from Example 1) | 100 min (flank wear = 0.12 mm) |
| Commercial reference leader | 45 min (flank wear = 0.15 mm) |

There is a significant improvement in comparison to the commercial reference which is optimised for this range of work piece hardness. This clearly expresses the superior wear resistance of the invented tool. The commercial tool failed to meet the demanded tool life, whereas the invented tool had a superior tool life with better cutting edge integrity.

### Example 3.

Inserts from Example 1 were tested and compared with inserts of a commercially available reference (grade, coating, shape) for the intended application area. This is a toughness demanding test in die and mould application before tempering the material. The machining situation was a very typical application. It represents, in terms of work piece hardness, the lower end of the application area in die and mould applications.

### Type of test

Semifinishing a cavity, with the cutter body orthogonally oriented to the bottom surface of the mould

| Work piece steel | DIN 1.2343 at 32 HRC |
|---|---|
| Cutting speed, Vc (m/min) | 196 |
| Insert ref: | RDHW12T3MOENF6-91 |
| Tooth feed, f_{z}, mm/tooth | 1 |
| Depth of cut,Axial/Radial(mm) | 1/35 |
| Cooling | dry |
| Tool life criterion | cutting time |
| | |

| Result: | |
|---|---|
| Invention (from Example 1) | 135 min |
| Commercial reference | 120 min |

The improvement compared to the commercial reference, which is fully designed for semi-finishing machining in this application, shows the excellent comportment of the invented tool.

### Example 4.

Inserts from Example 1 were tested and compared with inserts of a commercially available market reference (grade, coating, shape) for Milling -Finishing of heat resistant super alloys (HRSA).

**Test 1**

| Machine: | AXA VSC50 |
|---|---|
| Work piece: | INCONEL 718 |
| Cutting speed Vc (m/min) | 20 |
| Milling cutter reference | RT10032005QWC32050R |
| Insert ref: | RT100304R11 |
| Tooth feed, fz (mm/tooth) | 0.1 |
| Depth of cut Axial/Radial(mm) | 2 / 20 |
| Coolant: | Emulsion 6% |
| Tool life criterion | cutting time 22 min |

Result invention vs commercial reference leader
flank wear invention = 0.04 mm
flank wear commercial ref = 0.4 mm

**Test 2**

| | |
|---|---|
| Machine: | DMG DMU60T |
| Work piece: | UNS R 31537 (Co=28% ; Cr = 6 %) |
| Cutting speed Vc (m/min) | 20 |
| Milling cutter diameter | RT1002003QWC20030R |
| Insert ref: | RT100304R11 |
| Tooth feed, fz (mm/tooth) | 0.1 |
| Depth of cut Axial/Radial(mm) | 7 / 10 |
| Coolant: | Emulsion |

Result invention vs commercial reference leader
flank wear invention = 0.05 mm (cutting time 11 min)
flank wear commercial ref = 0.35 mm (cutting time 11 min)

### Example 5.

Inserts from Example 1 were tested and compared with inserts of a commercially available market reference (grade, coating, shape) for Milling-Finishing of Stainless Steel

**Test 1**

| | |
|---|---|
| Machine: | CU HURCO VMX80 |
| Work piece: | 304L |
| Cutting speed Vc (m/min) | 200 |
| Milling cutter reference | RT1002504CMC3040R |
| Insert ref: | RT10T3C5ER81 |
| Tooth feed, fz (mm/tooth) | 0.1 |
| Depth of cut Axial/Radial(mm) | 2 / 12 |
| Coolant: | Dry |
| Tool life criterion | cutting time 12 min |

Result invention vs commercial reference leader
Flank wear invention = 0.04 mm
flank wear commercial ref = 0.1 mm

**Test 2**

| | |
|---|---|
| Machine: | DMG DMU60T |
| Work piece: | 304L |
| Cutting speed Vc (m/min) | 150 |
| Milling cutter reference | RT1002003QWC20030R |
| Insert ref: | RT100304R11 |
| Tooth feed, fz (mm/tooth) | 0.07 |
| Depth of cut Axial/Radial(mm) | 2 / 15 |
| Coolant: | dry |

Result invention vs commercial reference leader
flank wear invention = 0.05 mm (cutting time 12 min)
flank wear commercial ref = 0.8 mm (cutting time 4 min)

### Example 6.

Inserts from Example 1 were tested and compared with inserts of a commercially available market reference (grade, coating, shape) for Milling-Finishing of Cast Iron

**Test 1**

| | |
|---|---|
| Machine: | LINEA |
| Work piece: | DIN 0.6030 |
| Cutting speed Vc (m/min) | 250 |
| Milling cutter ref = | NN85-12/125-24-AL40-063 |
| Insert ref: | SNHF1204FN-EN11ET |
| Tooth feed, fz (mm/tooth) | 0.05 |
| Depth of cut Axial/Radial(mm) | 0.07 / 175 |
| Coolant: | Emulsion |

Result invention vs commercial reference leader = Increase in tool life by 30%

**Test 2**

| | |
|---|---|
| Machine: | HERMLE U 1130 |
| Work piece: | DIN 0.7040 |
| Cutting speed Vc (m/min) | 300 |
| Milling cutter diameter | ∅160 |
| Insert ref: | TPKN1603PDSR2C |
| Tooth feed, fz (mm/tooth) | = 0.1 |
| Depth of cut Axial/Radial(mm) | 0.05 / 100 |
| Coolant: | Emulsion |

Result invention vs commercial reference leader
Flank wear invention = 0.1 mm
flank wear commercial ref = 0.3 mm

### Example 7.

Inserts from Example 1 were tested and compared with inserts of a commercially available market reference (grade, coating, shape) for Milling-Finishing of hard cast steel

**Test 1**

| | |
|---|---|
| Machine: | AXA VSC 50 |
| Work piece steel: | Austenitic steel with Carbides,C=1.15 (Hardness 55 HRC) |
| Cutting speed Vc (m/min) | 80 |
| Milling cutter diameter | ∅130 |
| Insert ref: | SPEN120408 |
| Tooth feed, fz (mm/tooth) | 0.2 |
| Depth of cut Axial/Radial(mm) | 1,5 / 25 |
| Coolant: | dry |

Result invention vs commercial reference leader
improvement of 20% in tool life

**Test 2**

| | |
|---|---|
| Machine: | DMG DMU60T |
| Work piece steel: | DIN 1.2739 (60 HRC) |
| Cutting speed Vc (m/min) | 65 |
| Milling cutter reference | RT1003205QWC32050R |
| Insert ref: | RT10T3C5R81 |
| Tooth feed, fz (mm/tooth) | 0.1 |
| Depth of cut Axial/Radial(mm) | 1 / 10 |
| Coolant: | Dry |

Result invention vs commercial reference leader
flank wear invention = 0.2 mm
flank wear commercial ref = 0.35 mm

### Example 8

Inserts from Example 1 were tested and compared with inserts of a commercially available market reference (grade, coating, shape) for Milling Semi Finishing & Light Roughing of tool steel

**Test 1**

| | |
|---|---|
| Machine: | Line C3N 2 FR |
| Work piece steel: | DIN 1.3401 |
| Cutting speed Vc (m/min) | 80 |
| Milling cutter diameter | ∅130 |
| Insert ref: | SPEN120408 |
| Tooth feed, fz (mm/tooth) | 0.3 |
| Depth of cut Axial/Radial(mm) | 2 / 10 |
| Coolant: | dry |

Result invention vs commercial reference leader
improvement of 30% in tool life

**Test 2**

| | |
|---|---|
| Machine: | AXA VSC50 |
| Work piece steel: | 1.2340 |
| Cutting speed Vc (m/min) | 100 |
| Milling cutter reference | RT1003205QWC32050R |
| Insert ref: | RT10T3C5R81 |
| Tooth feed, fz (mm/tooth) | 0.15 |
| Depth of cut Axial/Radial(mm) | 2 / 25 |
| Coolant: | Dry |

Result invention vs commercial reference leader
flank wear invention = 0.1 mm (9 parts machined)
flank wear commercial ref = 0.4 mm (1 part machined)

### Example 9.

Inserts from Example 1 were tested and compared with inserts of a commercially available market reference (grade, coating, shape) for Milling- SemiFinishing & Light Roughing of HRSA

**Test 1**

| | |
|---|---|
| Machine: | Milling Center |
| Work piece: | 2.4375 |
| Cutting speed Vc (m/min) | 100 |
| Milling cutter reference | PPH16/02-QW16-032 |
| Insert ref: | PPH1600CL1 |
| Tooth feed, fz (mm/tooth) | 0.1 |
| Depth of cut Axial/Radial(mm) | 0.25 / 0.25 |
| Coolant: | Emulsion |
| Tool life criterion | 5 parts |

Result invention vs commercial reference leader
flank wear invention = 0.06 mm
flank wear commercial ref = 0.3 mm

**Test 2**

| | |
|---|---|
| Machine: | CU Correa |
| Work piece: | STELLITE 21 |
| Cutting speed Vc (m/min) | 180 |
| Milling cutter diameter | PPH32/02-QC32-186 |
| Insert ref: | PPH3200CL1 |
| Tooth feed, fz (mm/tooth) | 0.16 |
| Depth of cut Axial/Radial(mm) | 1 / 1,6 |
| Coolant: | Yes |

Result invention vs commercial reference leader
cutting speed increased by 50 %

### Example 10.

Inserts from Example 1 were tested and compared with inserts of a commercially available market reference (grade, coating, shape) for Milling- Semi Finishing and Light Roughing of Stainless Steel

**Test 1**

| | |
|---|---|
| Machine: | CU HURCO VMX80 |
| Work piece: | 304L |
| Cutting speed Vc (m/min) | 120 |
| Milling cutter reference | RT1002504CMC3040R |
| Insert ref: | RT10T3C5ER81 |
| Tooth feed, fz (mm/tooth) | 0.15 |
| Depth of cut Axial/Radial(mm) | 2 / 10 |
| Coolant: | Dry |
| Tool life criterion | cutting time 5 min |

Result invention vs commercial reference leader
flank wear invention = 0.08 mm
flank wear commercial ref = 0.12 mm

**Test 2**

| | |
|---|---|
| Machine: | PCI Meteor 10 |
| Work piece: | 304L |
| Cutting speed Vc (m/min) | 150 |
| Milling cutter reference | RT1002003QWC20030R |
| Insert ref: | RT100308R31 |
| Tooth feed, fz (mm/tooth) | 0.1 |
| Depth of cut Axial/Radial(mm) | 2 / 15 |
| Coolant: | Yes |
| Tool life criterion | Max flank wear 0.3 mm |

Result invention vs commercial reference leader
Tool life multiplied by 3 with the invention

### Example 11.

Inserts from Example 1 were tested and compared with inserts of a commercially available market reference (grade, coating, shape) for Milling-Semi Finishing and Light Roughing of Cast Iron

**Test 1**

| | |
|---|---|
| Machine: | MAZAK VTC-20C |
| Work piece: | DIN 0.7040 |
| Cutting speed Vc (m/min)= | 177 |
| Milling cutter reference = | PS09/125-08-AL40-063R |
| Insert ref: | PDMT0905DESR-91 |
| Tooth feed, fz (mm/tooth) = | 0.28 |
| Depth of cut Axial/Radial(mm) | 1 / 50 |
| Coolant: | Emulsion |
| Tool life criterion | |

Result invention vs commercial reference leader
Flank wear invention = 0.1 mm
flank wear commercial ref = 0.3 mm

**Test 2**

| | |
|---|---|
| Machine: | Deckel Maho |
| Work piece: | EN-GJS-400-18-LT |
| Cutting speed Vc (m/min) | 200 |
| Milling cutter diameter | ∅125 |
| Insert ref: | SEKR1203AFEN41 |
| Tooth feed, fz (mm/tooth) | 0.25 |
| Depth of cut Axial/Radial(mm) | 1.5 / 100 |
| Coolant: | Emulsion |

Result invention vs commercial reference leader
Flank wear invention = 0.2 mm
flank wear commercial ref = 0.37 mm

### Example 12.

Inserts from Example 1 were tested and compared with inserts of a commercially available market reference (grade, coating, shape) for Turning - Finishing of hardened Steel

**Test 1**

| | |
|---|---|
| Machine: | SOMAB Unimab 500 |
| Work piece steel: | M2 (DIN 1.1003) HV=65 |
| Cutting speed Vc (m/min) | 50 |
| Insert ref: | DNMA150604 |
| Feed rate, (mm/rev) | 0.05 |
| Depth of cut, ap(mm) | 0.25 |
| Coolant: | Emulsion |
| Tool life criterion | 1 part |

Result invention vs commercial reference leader
flank wear invention = 0.11 mm
flank wear commercial ref = 0.21 mm

**Test 2**

| | |
|---|---|
| Machine: | SOMAB Unimab 500 |
| Work piece steel: | M2 (DIN 1.1003) HV = 65 |
| Cutting speed Vc (m/min) | 40 |
| insert ref: | TCGT0902022M |
| Feed rate, (mm/rev) | 0.04 |
| Depth of cut, ap(mm) | 0.5 |
| Coolant: | Emulsion |
| Tool life criterion | Max flank wear = 0.1 mm |

Result invention vs commercial reference leader
Tool life invention = 9 min
Tool life commercial reference leader = 3 min (CERMET)

### Example 13.

Inserts from Example 1 were tested and compared with inserts of a commercially available market reference (grade, coating, shape) for Turning -Finishing of Cast Iron

**Test 1**

| | |
|---|---|
| Machine: | FAMAR |
| Work piece: | FGL200 (NFA32011) |
| Cutting speed Vc (m/min)= | 300 |
| Insert ref: | CCMT09T30433 |
| Feed rate,(mm/rev) | 0.16 |
| Depth of cut, ap(mm) | 1 to 2 |
| Coolant: | Emulsion |

Result invention vs commercial reference leader = Tool life increased by 50%

**Test 2**

| | |
|---|---|
| Machine: | Mori Seiki |
| Work piece: | GL300 (EN-GJL-300) |
| Cutting speed Vc (m/min)= | 300 |
| Insert ref: | CNMA120412 |
| Feed rate,(mm/rev) | 0.15 |
| Depth of cut, ap(mm) | 0.5 |
| Coolant: | Emulsion |

Result invention vs commercial reference leader = Tool life increased by 30%

### Example 14.

Inserts from Example 1 were tested and compared with inserts of a commercially available market reference (grade, coating, shape) for Turning - Semi finishing & Light Roughing of hardened steel

**Test 1**

| | |
|---|---|
| Machine: | GILDEMEISTER |
| Work piece steel: | DIN 1.7228 (55 HRC) |
| Cutting speed Vc (m/min)= | 80 |
| Insert ref: | WNMA080408 |
| Feed rate,(mm/rev) | 0.1 |
| Depth of cut, ap(mm) | 2 |
| Coolant: | Emulsion |

Result invention vs commercial reference leader
flank wear invention = 0.25 mm
flank wear commercial ref = 0.5 mm

**Test 2**

| | |
|---|---|
| Machine: | Mori Seiki |
| Work piece steel: | DIN 1.2739 (60 HRC) |
| Cutting speed Vc (m/min)= | 70 |
| Insert ref: | CNGA120408 |
| Feed rate,(mm/rev) | 0.08 |
| Depth of cut, ap(mm) | 0.5 |
| Coolant: | Emulsion |

Result invention vs commercial reference leader = Tool life increased by 30%

### Example 15.

Inserts from Example 1 were tested and compared with inserts of a commercially available market reference (grade, coating, shape) for Turning semi-Finishing of HRSA

**Test 1**

| | |
|---|---|
| Machine: | MORANDO 80HP |
| Work piece steel: | INCONEL 706 |
| Cutting speed Vc (m/min) | 65 |
| Insert ref: | CNMG120412M2 |
| Feed rate,(mm/rev) | 0.25 |
| Depth of cut, ap(mm) | 0.3 |
| Coolant: | Emulsion |

Result invention vs commercial reference leader
tool life invention =11 min (20% better than reference leader)

**Test 2**

| | |
|---|---|
| Machine: | Bermhel TFM125M |
| Work piece steel: | INCONEL 718 |
| Cutting speed Vc (m/min) = | 28 |
| Insert ref: | DCMT11T304-2M |
| Feed rate,(mm/rev) | 0.08 |
| Depth of cut, ap(mm) | 0.5 |
| Coolant: | Emulsion |

Result invention vs commercial reference leader = increase tool life by 35%

### Example 16.

Inserts from Example 1 were tested and compared with inserts of a commercially available market reference (grade, coating, shape) for Turning - Semi finishing & Light Roughing of Stainless Steel

**Test 1**

| | |
|---|---|
| Machine: | WEISSER 1485 |
| Work piece steel: | DIN 1.4718 |
| Cutting speed Vc (m/min) | 130 |
| Insert ref: | RNMG120400-11 |
| Feed rate,(mm/rev) | 0.3 |
| Depth of cut, ap(mm) | 0.5 |
| Coolant: | Emulsion |

Result invention vs commercial reference leader
480 parts machined (valves) with invention
150 parts machined with commercial reference leader

**Test 2**

| | |
|---|---|
| Machine: | HERNAUL SOMUA |
| Work piece steel: | X1NiCrMoCu22-24-6 (URANUS B66) |
| Cutting speed Vc (m/min) | 80 |
| Insert ref: | CNMG120412M5 |
| Feed rate,(mm/rev) | 0.2 |
| Depth of cut, ap(mm) | 4 |
| Coolant: | Emulsion |

Result invention vs commercial reference leader
2 parts machined with the invention
1 part machined with the commercial reference leader

**Test 3**

| | |
|---|---|
| Machine: | SOMAB Unimab 500 |
| Work piece steel: | 316LTi (interrupted cut) |
| Cutting speed Vc (m/min) | 70 |
| Insert ref: | CNMG120412M2 |
| Feed rate,(mm/rev) | 0.2 |
| Depth of cut, ap(mm) | 0.25 |
| Coolant: | Emulsion |

Result invention vs commercial reference leader
tool life invention =14 min (three times better than reference leader)

### Example 17.

Inserts from Example 1 were tested and compared with inserts of a commercially available market reference (grade, coating, shape) for Turning - Semi finishing & Light Roughing of Cast Iron

**Test 1**

| | |
|---|---|
| Machine: | Nakamura |
| Work piece: | G25 (UNI 5007) |
| Cutting speed Vc (m/min)= | 300 |
| insert ref: | CNMA160612 |
| Feed rate,(mm/rev) | 0.5 |
| Depth of cut, ap(mm) | 4 |
| Coolant: | Emulsion |

Result invention vs commercial reference leader = Tool life increased by 20%

**Test 2**

| | |
|---|---|
| Machine: | Diedsheim |
| Work piece: | FGS50 (EN-GJS 5007) |
| Cutting speed Vc (m/min)= | 150 |
| Insert ref: | CNMG160616-7B |
| Feed rate,(mm/rev) | 0.5 |
| Depth of cut, ap(mm) | 3 |
| Coolant: | Emulsion |

Result invention vs commercial reference leader
flank wear invention = 0.2 mm
flank wear commercial ref = 0.45 mm

## Claims

1. Cemented carbide cutting tool insert for semifinishing or finishing metal cutting operations, comprising a substrate and a wear resistant coating, of different shapes wherein
- the substrate comprises in addition to WC, 5.5-8.5 wt-% Co and Cr such that the Cr/Co weight ratio is 0.08-0.12, and also Ti and Ta in such amounts that the ratio of Me/Co=(at%Ti+at%Ta)/at%Co is less than or equal to 0.014-(CW-Cr)*0.008 and higher than 0.0005 and the CW-Cr is 0.75-0.95, whereby the CW-Cr is defined as
CW-Cr= (magnetic-% Co +1.13*wt-%Cr)/wt-%Co
where magnetic-% Co is the weight percentage of magnetic Co and wt-% Co is the weight percentage of Co in the cemented carbide and the coercivity is >20 kA/m, and
- the wear resistant coating is a homogeneous Al_{X}Ti₁₋ₓN-layer with x=0.6-0.67, with thickness of >1 µm, but <3.8 µm, both composition and thickness being measured on the flank face 0.2 mm below the nose radius and in the centre of the cutting edge.

2. A cemented carbide cutting tool insert according to claim 1 **characterized in that** the substrate comprises 6-8 wt-% Co and Cr such that the Cr/Co weight ratio is 0.09-0.11, Ti and Ta in such amounts that the ratio of Me/Co=(at%Ti+at%Ta)/at%Co is higher than 0.0007 and the CW-Cr is 0.78-0.93 and that the coercivity is 23-29 kA/m.

3. A cemented carbide cutting tool insert according to any of the preceding claims **characterized in that** the thickness of the wear resistant coating is >1.8 µm but <3.0 µm and x=0.62.

4. Method of making a cemented carbide cutting tool insert for semifinishing or finishing metal cutting operations, comprising a substrate, a wear resistant coating and different shapes
having the following steps
- providing a substrate comprising in addition to WC, 5.5-8.5 wt-% Co and Cr such that the Cr/Co weight ratio is 0.08-0.12 and also Ti and Ta in such amounts that the ratio of Me/Co=(at%Ti+at%Ta)/at%Co is less than or equal to 0.014-(CW-Cr)*0.008 and higher than 0.0005 and the CW-Cr is 0.75-0.95, whereby the CW-Cr is defined as
CW-Cr= (magnetic-% Co +1.13*wt-%Cr)/wt-%Co
where magnetic-% Co is the weight percentage of magnetic Co and wt-% Co is the weight percentage of Co in the cemented carbide and the coercivity is >20 kA/m, by:
- wet milling submicron powders of tungsten carbide, cobalt, Ti and Ta added as TiC, TaC, (Ti,W)C, (Ta,W)C or (Ti,Ta,W)C and at least one of Cr₃C₂, Cr₂₃C₆ and Cr₇C₃ to obtain a slurry,
- drying the slurry to obtain a powder,
- pressing the powder to inserts,
- sintering the inserts in vacuum, and
- depositing by arc evaporation technique whilst maintaining a partial pressure of nitrogen in the recipient, and using the appropriate selection of active evaporation sources and -rates a wear resistant coating comprising a homogeneous AlₓTi₁₋ₓN-layer with x=0.6-0.67, and a thickness of the layer of >1 µm, but <3.8 µm, the composition and the thickness being measured on the flank face 0.2 mm below the nose radius and in the centre of the cutting edge.

5. A method according to claim 4 **characterized in that** the substrate comprises 6-8 wt-% Co and Cr such that the Cr/Co weight ratio is 0.09-0.11, Ti and Ta in such amounts that the ratio of Me/Co=(at%Ti+at%Ta)/at%Co is higher than 0.0007 and the CW-Cr is 0.78-0.93 and that the coercivity is 23-29 kA/m.

6. A method according to any of claims 4-5
**characterized in that** the thickness of the wear resistant coating is >1.8 µm but<3.0 µm and x=0.62.

7. A method according to any of claims 4-6
**characterized in that** an isostatic gas pressure step is performed during sintering temperature or at the final stage of sintering.

8. A method according to any of claims 4-7
**characterized in that** the inserts are grinded into requested shapes.

9. Use of an insert according to claim 1 for die and mould semifinishing and finishing operations in milling applications of work pieces with a hardness of 30-65 HRC.

10. Use of an insert according to claim 1 for machining of heat resistant super alloys(HRSA), as Inconel 718, Inconel 625, Waspaloy, Udimet 720,
- at cutting speeds of 20 - 180 m/min, feed rates of 0.05 - 0.3 mm/rev and depth of cut of 0.2 - 0.6 mm in turning applications and
- at cutting speeds of 15 - 180 m/min, tooth feed of 0.05 - 0.2 mm/tooth and axial depth of cut of 0.25 - 7 mm in milling applications.

11. Use of an insert according to claim 1 for machining of stainless steel, as AISI/SAE 304, San-Mac 316L, SAF2205, SAF2507,
- at cutting speeds of 70 - 200 m/min, feed rates of 0.1 - 0.4 mm/rev and depth of cut of 0.3 - 2.5 mm in turning applications and
- at cutting speeds of 60 - 200 m/min, tooth feed of 0.05 - 0.2 mm/tooth and axial depth of cut of 0.5 - 2.5 mm in milling applications.

12. Use of an insert according to claim 1 for milling of tool steel, at a cutting speed from 70 up to 120 m/min, a feed from 0.1 to 0.35 mm/tooth and depth of cut from 1 to 3 mm.

13. Use of an insert according to claim 1 for turning of hardened steel, at a cutting speed from 40 up to 60 m/min and a feed from 0.03 to 0.05 mm/rev and depth of cut from 0.2 to 0.5 mm.

14. Use of an insert according to claim 1 for milling of hard cast steel, at a cutting speed from 50 up to 100 m/min and a feed from 0.1 to 0.3 mm/tooth and depth of cut from 0.5 to 1,5 mm.

15. Use of an insert according to claim 1 for machining of cast iron,
- at cutting speeds of 200 - 400 m/min, feed rates of 0.1 - 0.5 mm/rev and depth of cut of 0.5 - 4 mm in turning applications and
- at cutting speeds of 150 - 350 m/min, tooth feed of 0.05 - 0.3 mm/tooth and axial depth of cut of 0.05 - 2.5 mm in milling applications.

## Patentansprüche

1. Hartmetallschneidwerkzeugeinsatz für semi-feinbearbeitende oder feinbearbeitende Metallschneidvorgänge mit einem Substrat und einer verschleißbeständigen Beschichtung in unterschiedlichen Formen, wobei
- das Substrat zusätzlich zu WC 5,5-8,5 Gew.-% Co und Cr enthält, so dass das Gewichtsverhältnis von Cr/Co 0,08-0,12 beträgt, und auch Ti und Ta in solchen Mengen enthält, dass das Verhältnis von Me/Co = (At.-% Ti + At.-% Ta)/At.-% Co weniger als oder gleich 0,014 - (CW-Cr) x 0,008 und mehr als 0,0005 beträgt und der CW-Cr 0,75-0,95 ist, wobei der CW-Cr definiert ist als CW-Cr = (% magnetisches Co + 1,13 x Gew.-% Cr)/Gew.-% Co,
wobei % magnetisches Co der prozentuale Gewichtsanteil von magnetischem Co ist und Gew.-% Co der prozentuale Gewichtsanteil von Co in dem Hartmetall ist und die Koerzitivität > 20 kA/m beträgt, und
- die verschleißbeständige Beschichtung eine homogene AlₓTi₁₋ₓN-Lage ist mit x = 0,6-0,67 mit einer Dicke von > 1µm, aber < 3,8 µm, wobei sowohl die Zusammensetzung als auch die Dicke auf der Freifläche 0,2 mm unterhalb der Krümmung der Schneidkante und im Zentrum der Schneidkante gemessen werden.

2. Hartmetallschneidwerkzeugeinsatz nach Anspruch 1, **dadurch gekennzeichnet, dass** das Substrat 6-8 Gew.-% Co und Cr enthält, so dass das Gewichtsverhältnis von Cr/Co 0,09 bis 0,11 beträgt, Ti und Ta in solchen Mengen enthält, dass das Verhältnis von Me/Co = (At.- % Ti + At.-% Ta)/At.-% Co größer ist als 0,0007 und der CW-Cr 0,78-0,93 beträgt und dass die Koerzitivität 23-29 kA/m ist.

3. Hartmetallschneidwerkzeugeinsatz nach einem der vorangegangenen Ansprüche, **dadurch gekennzeichnet, dass** die Dicke der verschleißbeständigen Beschichtung > 1,8 µm, aber < 3,0 µm ist und x = 0,62.

4. Verfahren zur Herstellung eines Hartmetallschneidwerkzeugeinsatzes für semi-feinbearbeitende oder feinbearbeitende Metallschneidvorgänge, welche ein Substrat, eine verschleißbeständige Beschichtung und verschiedene Formen aufweist, mit den folgenden Stufen:
- Bereitstellen eines Substrates, welches zusätzlich zu WC 5,5-8,5 Gew.-% Co und Cr enthält, so dass das Gewichtsverhältnis von Cr/Co 0,08-0,12 beträgt, und auch Ti und Ta in solchen Mengen enthält, dass das Verhältnis von Me/Co = (At.-% Ti + At.-% Ta)/At.-% Co weniger als oder gleich 0,014 - (CW-Cr) x 0,008 und mehr als 0,0005 beträgt und der CW-Cr 0,75-0,95 ist, wobei der CW-Cr definiert ist als
CW-Cr = (% magnetisches Co + 1,13 x Gew.-% Cr)/Gew.-% Co,
wobei % magnetisches Co der prozentuale Gewichtsanteil von magnetischem Co ist und Gew.-% Co der prozentuale Gewichtsanteil von Co in dem Hartmetall ist und die Koerzitivität > 20 kA/m beträgt, indem man
- Submikronpulver von Wolframcarbid, Kobalt, Ti und Ta, zugegeben als TiC, TaC, (Ti,W)C, (Ta,W)C oder (Ti,Ta,W)C, und wenigstens eines unter Cr₃C₂, Cr₂₃C₆ und Cr₇C₃ unter Erhalt einer Aufschlämmung nass vermahlt,
- die Aufschlämmung unter Erhalt eines Pulvers trocknet,
- das Pulver zu Einsätzen presst,
- die Einsätze unter Vakuum sintert und
- mittels Lichtbogenverdampfungstechnik unter Aufrechterhaltung eines Stickstoffpartialdrucks in der Kammer und unter Anwendung der geeigneten Auswahl aktiver Verdampfungsquellen und -raten eine verschleißbeständige Beschichtung abscheidet, die eine homogene AlₓTi₁₋ₓN-Lage mit x = 0,6-0,67 und einer Dicke der Lage von > 1 µm, aber < 3,8 µm aufweist, wobei die Zusammensetzung und die Dicke auf der Freifläche 0,2 mm unter der Krümmung der Schneidkante und im Zetrum der Schneidkante gemessen werden.

5. Verfahren nach Anspruch 4, **dadurch gekennzeichnet, dass** das Substrat 6-8 Gew.-% Co und Cr aufweist, so dass das Gewichtsverhältnis von Cr/Co 0,09-0,11 beträgt, Ti und Ta in solchen Mengen enthält, dass das Verhältnis von Me/Co = (At.-% Ti + At.-% Ta)/At.-% Co größer ist als 0,0007 und der CW-Cr 0,78-0,93 beträgt und dass die Koerzitivität 23-29 kA/m ist.

6. Verfahren nach einem der Ansprüche 4 bis 5, **dadurch gekennzeichnet, dass** die Dicke der verschleißbeständigen Beschichtung > 1,8 µm, aber < 3,0 µm ist und x = 0,62.

7. Verfahren nach einem der Ansprüche 4 bis 6, **dadurch gekennzeichnet, dass** während der Sintertemperatur oder im Endstadium des Sinterns eine Stufe unter isostatischem Gasdruck durchgeführt wird.

8. Verfahren nach einem der Ansprüche 4 bis 7, **dadurch gekennzeichnet, dass** die Einsätze durch Schleifen in die geforderten Formen gebracht werden.

9. Verwendung eines Einsatzes nach Anspruch 1 für Semi-Feinbearbeitungs- und Feinbearbeitungsvorgänge an Ausformwerkzeugen und Formen in Fräsanwendungen an Werkstücken mit einer Härte von 30 bis 65 HRC.

10. Verwendung eines Einsatzes nach Anspruch 1 für die Bearbeitung von hitzebeständigen Superlegierungen (HRSA), wie Inconel 718, Inconel 625, Waspaloy, Udimet 720
- bei Schnittgeschwindigkeiten von 20-180 m/min, Zuführgeschwindigkeiten von 0,05-0,3 mm/Umdrehung und einer Schnitttiefe von 0,2-0,6 mm in Drehanwendungen und
- bei Schnittgeschwindigkeiten von 15-180 m/min, einem Zahnvorschub von 0,05-0,2 mm/Zahn und einer axialen Schnitttiefe von 0,25-7 mm in Fräsanwendungen.

11. Verwendung eines Einsatzes nach Anspruch 1 für die Bearbeitung von rostfreiem Stahl, wie AISI/SAE 304, San-Mac 316L, SAF2205, SAF2507
- bei Schnittgeschwindigkeiten von 70-200 m/min, Zuführgeschwindigkeiten von 0,1-0,4 mm/Umdrehung und einer Schnitttiefe von 0,3-2,5 mm in Drehanwendungen und
- bei Schnittgeschwindigkeiten von 60-200 m/min, einem Zahnvorschub von 0,05-0,2 mm/Zahn und einer axialen Schnitttiefe von 0,5-2,5 mm in Fräsanwendungen.

12. Verwendung eines Einsatzes nach Anspruch 1 zum Fräsen von Werkzeugstahl bei einer Schnittgeschwindigkeit von 70 bis zu 120 m/min, einer Zuführung von 0,1-0,35 mm/Zahn und einer Schnitttiefe von 1-3 mm.

13. Verwendung eines Einsatzes nach Anspruch 1 für das Drehen von gehärtetem Stahl bei einer Schnittgeschwindigkeit von 40 bis zu 60 m/min und einer Zuführung von 0,03-0,05 mm/Umdrehung und einer Schnitttiefe von 0,2-0,5 mm.

14. Verwendung eines Einsatzes nach Anspruch 1 für das Fräsen von hartem Gussstahl mit einer Schnittgeschwindigkeit von 50 bis zu 100 m/min und einer Zuführung von 0,1-0,3 mm/Zahn und einer Schnitttiefe von 0,5-1,5 mm.

15. Verwendung eines Einsatzes nach Anspruch 1 für die Bearbeitung von Gusseisen
- bei Schnittgeschwindigkeiten von 200-400 m/min, Zuführgeschwindigkeiten von 0,1-0,5 mm/Umdrehung und einer Schnitttiefe von 0,5-4 mm in Drehanwendungen und
- Schnittgeschwindigkeiten von 150-350 m/min, einem Zahnvorschub von 0,05-0,3 mm/Zahn und einer axialen Schnittgeschwindigkeit von 0,05-2,5 mm in Fräsanwendungen.

## Revendications

1. Insert d'outil de coupe en carbure cémenté, pour des opérations de coupe de métaux en semi-finition ou en finition, comprenant un substrat et un revêtement résistant à l'usure, de différentes formes, dans lequel :
- le substrat comprend, en plus de WC, de 5,5 à 8,5 % en poids de Co et Cr, de manière que le rapport Cr/Co, exprimé en poids, soit dans la fourchette comprise entre 0,08 et 0,12, et également Ti et Ta, en des quantités telles que le rapport Me/Co=(% at. Ti + % at. Ta)/ % at. Co soit inférieur ou égal à 0,014-(CW-Cr)*0,008, et supérieur à 0,0005, et le rapport CW-Cr dans la fourchette de 0,79 à 0,95, de manière que CW-Cr soit défini comme étant :
CW-Cr = (% de Co magnétique + 1,13*% en poids de Cr)/% en poids de Co,
dans lequel le % de Co magnétique est le pourcentage en poids de Co magnétique et le % en poids de Co est le pourcentage en poids de Co dans le carbure cémenté, et la coercivité est > 20 kA/m, et
- le revêtement résistant à l'usure est une couche homogène de AlₓTi₁₋ₓN, avec x dans la fourchette de 0,6 à 0,67, avec une épaisseur >1 µm, mais <3,8 µm, la composition et l'épaisseur étant toutes deux mesurées sur la face de flanc 0,2 mm au-dessous du rayon de nez et au centre du bord de coupe.

2. Insert d'outil de coupe en carbure cémenté selon la revendication 1, **caractérisé en ce que** le substrat comprend de 6 à 8 % en poids de Co et Cr, de manière que le rapport Cr/Co, exprimé en poids, soit dans la fourchette comprise entre 0,09 et 0,11, Ti et Ta étant en des quantités telles que le rapport Me/Co=(% at. Ti + % at. Ta)/ % at. Co soit supérieur 0,0007, et le rapport CW-Cr est dans la fourchette de 0,78 à 0,93, et la coercivité est dans la fourchette comprise entre 23 et 29 kA/m.

3. Insert d'outil de coupe en carbure cémenté selon l'une quelconque des revendications précédentes, **caractérisé en ce que** l'épaisseur du revêtement résistant à l'usure est > 1,8 µm, mais < 3,0 µm et x = 0,62.

4. Procédé de fabrication d'un insert d'outil de coupe en carbure cémenté pour des opérations de coupe de métaux en semi-finition ou en finition, comprenant un substrat, un revêtement résistant à l'usure et différentes formes, comprenant les étapes suivantes :
- fourniture d'un substrat comprenant, en plus de WC, de 5,5 à 8,5 % en poids de Co et Cr, de manière que le rapport Cr/Co, exprimé en poids, soit dans la fourchette comprise entre 0,08 et 0,12, et également Ti et Ta, en des quantités telles que le rapport Me/Co=(% at. Ti + % at. Ta)/ % at. Co soit inférieur ou égal à 0,014-(CW_Cr)*0,008 et supérieur 0,0005, et que le rapport CW-Cr soit dans la fourchette de 0,75 à 0,95, de manière que le rapport CW-Cr soit défini comme étant :
CW_Cr = (% de Co magnétique + 1,13*% en poids de Cr)/% en poids de Co,
dans lequel le % de Co magnétique est le pourcentage en poids de Co magnétique et le % en poids de Co est le pourcentage en poids de Co dans le carbure cémenté, et la coercivité est > 20 kA/m, par :
- broyage humide de poudres submicroniques de carbure de tungstène, cobalt et Ti et Ta ajouté sous forme de TiC, TaC, (Ti,W)C, (Ta,W)C ou (Ti,Ta,W)C et au moins l'un de Cr₃C₂, Cr₂₃C₆ et Cr₇C₃, pour obtenir une boue,
- séchage de la boue pour obtenir une poudre,
- pressage de la poudre pour obtenir des inserts,
- frittage des inserts sous vide, et
- déposition par une technique d'évaporation à l'arc, tout en maintenant une pression partielle d'azote dans le récipient, et utilisation de la sélection appropriée de sources et débits d'évaporation active, un revêtement résistant à l'usure comprenant une couche homogène de AlₓTi₁₋ₓN_{,} avec x dans la fourchette de 0,6 à 0,67, avec une épaisseur > 1 µm, mais < 3,8 µm, la composition et l'épaisseur étant toutes deux mesurées sur la face de flanc 0,2 mm au-dessous du rayon de nez et au centre du bord de coupe.

5. Procédé selon la revendication 4, **caractérisé en ce que** le substrat comprend de 6 à 8 % en poids de Co et Cr, de manière que le rapport Cr/Co, exprimé en poids, soit dans la fourchette comprise entre 0,09 et 0,11, Ti et Ta étant en des quantités telles que le rapport Me/Co=(% at. Ti + % at. Ta)/ % at. Co soit supérieur à 0,0007, et le rapport CW-Cr est dans la fourchette de 0,78 à 0,93, et la coercivité est dans la fourchette comprise entre 23 et 29 kA/m.

6. Procédé selon l'une quelconque des revendications 4 à 5,
**caractérisé en ce que** l'épaisseur du revêtement résistant à l'usure est > 1,8 µm, mais < 3,0 µm et x = 0,62.

7. Procédé selon l'une quelconque des revendications 4 à 6,
**caractérisé en ce qu'**une étape d'exposition à une pression de gaz isostatique est effectuée pendant que l'on est à la température de frittage ou à l'étape finale de frittage.

8. Procédé selon l'une quelconque des revendications 4 à 7,
**caractérisé en ce que** les inserts sont abrasés pour prendre des formes requises.

9. Utilisation d'un insert selon la revendication 1, pour des opérations de moulage sous pression et atmosphérique en semi-finition ou en finition, dans des opérations de fraisage de pièces d'oeuvre d'une dureté dans la fourchette de 30 à 65 HRC.

10. Utilisation d'un insert selon la revendication 1, pour l'usinage de super alliages résistants à la chaleur (HRSA), tels que l'Inconel 718, l'Inconel 625, le Waspaloy, l'Udimet 720,
à des vitesses de coupe dans la fourchette comprise entre 20 et 180 m/min, des avances de 0,05 à 0,3 mm/tour et une profondeur de coupe de 0,2 à 0,6 mm dans des applications de tournage, et
à des vitesses de coupe dans la fourchette comprise entre 15 et 180 m/min, des avances de dent 0,05 à 0,2 mm/dent et une profondeur axiale de coupe de 0,25 à 7 mm dans des applications de fraisage.

11. Utilisation d'un insert selon la revendication 1, pour l'usinage d'acier inoxydable, tels que AISI/SAE 304, San-Mac 316L, SAF2205, SAF2507,
à des vitesses de coupe dans la fourchette comprise entre 70 et 200 m/min, des avances de 0,1 à 0,4 mm/tour et une profondeur de coupe de 0,3 à 2,5 mm dans des applications de tournage, et
à des vitesses de coupe dans la fourchette comprise entre 60 et 200 m/min, des avances de dent 0,05 à 0,2 mm/dent et une profondeur axiale de coupe de 0,5 à 2,5 mm dans des applications de fraisage.

12. Utilisation d'un insert selon la revendication 1, pour fraiser de l'acier à outil, à une vitesse de coupe dans la fourchette comprise entre 70 et 120 m/min, une avance de 0,1 à 0,35 mm/dent et une profondeur de coupe de 1 à 3 mm.

13. Utilisation d'un insert selon la revendication 1, pour tourner de l'acier trempé, à une vitesse de coupe dans la fourchette comprise entre 40 et 60 m/min, des avances de 0,03 à 0,05 mm/dent et une profondeur de coupe de 0,2 à 0,5 mm.

14. Utilisation d'un insert selon la revendication 1, pour le fraisage d'acier moulé dur, à une vitesse de coupe dans la fourchette comprise entre 50 et 100 m/min, et une avance de 0,1 à 0,3 mm/dent et une profondeur de coupe de 0,5 à 1,5 mm.

15. Utilisation d'un insert selon la revendication 1, pour usiner de la fonte, à des vitesses de coupe dans la fourchette comprise entre 200 et 400 m/min, des avances de 0,1 à 0,5 mm/tour et une profondeur de coupe de 0,5 à 4 mm dans des applications de tournage, et
à des vitesses de coupe dans la fourchette comprise entre 150 et 350 m/min, des avances de dent 0,05 à 0,3 mm/dent et une profondeur axiale de 0,05 à 2,5 mm dans des applications de fraisage.
